# EUROPÄISCHE PATENTSCHRIFT

(11) **EP 2 489 082 B1**
(45) Veröffentlichungstag und Bekanntmachung des Hinweises auf die Patenterteilung: **01.01.2014**
(21) Anmeldenummer: 10795912.4
(22) Anmeldetag: 12.10.2010
(51) Int. Cl.: H01L 41/047, H01L 41/083

(54) **PIEZOELEKTRISCHER MEHRSCHICHTAKTUATOR**
MULTILAYER PIEZOELECTRIC ACTUATOR
ACTIONNEUR MULTICOUCHE PIÉZOÉLECTRIQUE

(30) Priorität: 17.10.2009 DE 102009049718
(43) Veröffentlichungstag der Anmeldung: 22.08.2012
(73) Patentinhaber: Pi Ceramic GmbH Keramische Technologien und Bauelemente, 07589 Lederhose (DE)
(72) Erfinder: HENNIG, Eberhard, 07646 Mörsdorf (DE); DITAS, Peter, 07589 Münchenbernsdorf (DE); KOPSCH, Daniel, 07570 Weida (DE)
(74) Vertreter: Klitzsch, Gottfried
(86) Internationale Anmeldenummer: PCT/DE2010/001194
(87) Internationale Veröffentlichungsnummer: WO 2011/044882

(56) Entgegenhaltungen:
- DE-A1-102004 057 795
- JP-A- 9 181 368
- JP-A- 2003 243 740

## Beschreibung

Die Erfindung betrifft einen piezokeramischen Mehrschichtaktuator gemäß dem Oberbegriff des unabhängigen Patentanspruchs 1. Ein derartiger piezokeramischer Mehrschichtaktuator ist aus der JP 09-181368 A bekannt.

Ein Mehrschichtaktuator bzw. Multilayeraktor der oben genannten Art ist aus der DE 10 2006 040 316 A1 bekannt. Dort ist ein plezoelektrischer Flächenaktuator und ein Verfahren zu seiner Herstellung beschrieben. Kernstück ist ein herkömmlicher piezoelektrischer Multilayeraktuator, dessen Außenkontaktierungen (Sammelelektroden) mit an sich bekannten elastischen Kontaktflächen versehen werden, wobei aus dem so vorbereiteten Körper dann dünne Platten gesägt werden, die in ein Polymer eingebettet werden. Die elektrische Kontaktlerung der dünnen Multilayerplatte erfolgt über in die Polymereinbettung integrierte Leiterbahnen. Dabei ist es wichtig, dass bei dem Klebeprozess oder dem Harzinjektionsverfahren eine galvanische Verbindung zwischen den Leiterbahnen und den elastischen Kontaktflächen erreicht wird. Eine derartige Anordnung und Technologie ist allein im Sinne einer stabilen Serienfertigung schon als kritisch zu bewerten. Versuche haben gezeigt, dass mit der vorgeschlagenen Kontaktierung keine zuverlässige Herstellung derartiger Aktoren möglich ist.

Aus der JP 2003-243740 A ist ein piezoelektrischer Mehrschichtaktuator bekannt, bei welchem die elektrische Kontaktierung der Sammelelektroden über Auskopplungselektroden gewährleistet ist, wobei sich die Auskopplungselektroden in Abstand zu den für die Auslenkung des Aktors zuständigen inneren Elektroden befinden und selbst elektrisch mit einer aus dem Aktor herausführenden Verbindungsleitung verbunden sind.

Die JP 07-131084 A beschreibt einen piezoelektrischen Mehrschichtaktuator, bei welchem die seitlichen Sammelelektroden über an der Ober- und Unterseite des Aktors angeordnete, flächige Elektroden mit elektrischer Spannung versorgt werden. Hierzu existieren mit leitfähigem Material gefüllte Poren, die zwischen den Sammelelektroden an Ober- und Unterseite und den sich im Inneren des Aktors anschließenden inneren Elektroden angeordnet sind. Die JP 09-181368 A offenbart einen direkt mit einer Leiterplatte verbundenen piezoelektrischen Mehrschichtaktor, wobei die elektrische Kontaktierung der Sammelelektroden über am Fuße des Aktors angeordnete Elektrodenlagen realisiert wird. Durch entsprechende Bohrungen in der Leiterplatte sind Verbindungselektroden an die am Fuße des Aktors angeordneten Elektrodenlagen herangeführt.

Es ist daher die Aufgabe der Erfindung, eine zuverlässige Kontaktierung zwischen den Elektroden des piezoelektrischen Mehrschichtaktuators und der Außenkontaktierung sicher zu stellen, wobei eine gleichmäßige Spannungsfestigkeit im gesamten Aktuator gewährleistet wird.

Zur Lösung dieser Aufgabe stellt die Erfindung einen piezokeramischen Mehrschichtaktuator mit den Merkmalen des Anspruchs 1 bereit.

Grundgedanke der Erfindung ist es, die zuverlässige Kontaktierung zwischen den Elektroden des piezoelektrischen Multilayeraktuators und der Außenkontaktierung dadurch sicher zu stellen, dass die Kontaktflächen deutlich vergrößert werden. Erfindungsgemäß kann das dadurch erreicht werden, dass der Aktorkörper bereits im grünen Zustand mit Kontaktierungselektroden versehen wird. Terminologisch werden die Begriffe "Innenelektrode", "Kontaktierungselektrode" und "Sammelelektrode" unterschieden. Der Begriff "Innenelektrode" bezeichnet im Rahmen dieser Erfindung eine positive oder negative Elektrode, die eine Piezokeramikschicht flächig elektrodiert, um einen (inversen) piezoelektrischen Effekt zu erzeugen, bei welchem die elektrodierte Piezokeramikschicht ihre Form unter dem Einfluss eines elektrischen Feldes ändert, um eine aktuatorische Nutzung der Piezokeramik zu ermöglichen, oder um einen direkten piezoelektrischen Effekt zu erzeugen, bei welchem durch die Einwirkung einer mechanischen Spannung oder Dehnung Ladungen an den Innenelektroden generiert werden. Der Begriff "Sammelelektrode" bezeichnet im Rahmen dieser Erfindung eine Elektrode, über welche die zugeordneten positiven oder negativen Innenelektroden elektrisch gespeist werden. Der Begriff "Kontaktierungselektrode" bezeichnet im Rahmen dieser Erfindung eine Elektrode, über welche der Mehrschichtaktuator elektrisch kontaktiert wird und über welche die zugeordneten positiven oder negativen Sammelelektroden elektrisch gespeist werden. Die Kontaktierungselektroden sind vorzugsweise elektrisch gegeneinander isoliert. Der Begriff "leitend" wird im Rahmen dieser Erfindung als "elektrisch leitend" verstanden.

In einer vorteilhaften Weiterbildung der Erfindung reicht die positive und/oder die negative Kontaktierungselektrode an zumindest eine Außenseite, vorzugsweise zwei Außenseiten, des Aktorkörpers, und schließt bevorzugt bündig mit der oder den Außenseiten des Aktorkörpers ab. Vorzugsweise liegt die positive und/oder die negative Kontaktierungselektrode an zumindest einer Außenseite des Aktorkörpers frei und ist zur elektrischen Kontaktierung zugänglich. Zur Herstellung des piezoelektrischen Multilayeraktuators wird eine Vielzahl von Piezokeramikschichten aufeinander gestapelt, die alternierend durch jeweils eine positive oder negative Innenelektrode voneinander getrennt sind, um einen quaderförmigen Aktorkörper zu bilden, der auch als Multilayerstack bezeichnet werden kann. Der quaderförmige Aktorkörper wird anschließend im wesentlichen senkrecht zur Erstreckungsebene der Piezokeramikschichten in eine Vielzahl plattenförmiger piezokeramischen Flächenaktuatoren zersägt. Nach dem Sägeprozess sind die eingebrachten Kontaktierungselektroden vorzugsweise von den Hauptflächen der Flächenaktuatoren für eine elektrische Kontaktierung zugänglich. Die elektrische Kontaktierung der Kontaktierungselektroden erfolgt bevorzugt über Kontaktierungssammelelektroden, die zusätzlich auf die Außenseiten des Aktorkörpers aufgebracht werden, die zwischen den mit Sammelelektroden versehenen Außenseiten des Aktorkörpers liegen.

Es kann hilfreich sein, wenn die positive und/oder die negative Kontaktierungselektrode eine Innenseite der zugeordneten positiven oder negativen Sammelelektrode unmittelbar kontaktiert. Dadurch kann eine optimale leitende Verbindung zwischen den positiven und negativen Kontaktierungselektroden und den zugeordneten positiven oder negativen Sammelelektroden sichergestellt werden.

Es kann sich als praktisch erweisen, wenn die Sammelelektroden auf zwei sich gegenüberliegenden Außenseiten des Aktorkörpers angeordnet sind. Dadurch kann die Herstellung von piezokeramischen Flächenaktuatoren erheblich vereinfacht werden. Die Sammelelektroden werden auf zwei sich gegenüberliegenden Außenseiten eines Multilayerstacks aufgebracht, der anschließend zersägt wird, so dass die Sammelelektroden nach dem Sägeprozess leitend mit den zugeordneten positiven oder negativen Kontaktierungselektroden sowie mit den zugeordneten positiven oder negativen Innenelektroden verbunden bleiben.

Es kann von Vorteil sein, wenn der Aktorkörper des piezokeramischen Mehrschichtaktuators quaderförmig oder plattenfömig ausgebildet ist. Derartige Geometrien eignen sich für die meisten gängigen Anwendungen, insbesondere als Flächenaktuator.

In einer vorteilhaften Weiterbildung der Erfindung weist der Aktorkörper zumindest einen passiven Bereich auf, der außerhalb der äußersten beiden Innenelektroden liegt, wobei die positive und/oder die negative Kontaktierungselektrode innerhalb des passiven Bereichs angeordnet ist. Der aktive Bereich des Aktorkörpers umfasst die Vielzahl von Piezokeramikschichten, die alternierend durch jeweils eine positive oder negative Innenelektrode voneinander getrennt sind, und ist durch die äußersten beiden Innenelektroden begrenzt. Der passive Bereich liegt außerhalb der äußersten beiden Innenelektroden, wobei dieser Bereich nicht vorrangig der Erzeugung eines (inversen) piezokeramischen Effekts dient bzw. die darin befindlichen Schichten nicht oder nicht vorrangig aktuatorisch genutzt werden. Vorzugsweise wird der Aktorkörper bereits im grünen Zustand mit passiven Endschichten versehen und in die passiven Endschichten werden die Kontaktierungselektroden eingebracht, die an den eigentlichen Kontaktflächen des Aktuators bis an die Oberfläche reichen und die in der Mitte des Aktuators elektrisch gegeneinander isoliert sind.

Es kann nützlich sein, wenn der passive Bereich zumindest eine Piezokeramikschicht aufweist. Wenn in den aktiven und passiven Bereichen identische Materialien mit identischen Werkstoffeigenschaften eingesetzt werden, lassen sich Schäden aufgrund unverträglicher Materialpaarungen, die bspw. durch Dehnungsspannungen hervorgerufen werden, weitgehend vermeiden.

Es kann sich als hilfreich erweisen, wenn der Aktorkörper mehrere passive Bereiche aufweist, in welchen mindestens eine positive und/oder mindestens eine negative Kontaktierungselektrode angeordnet ist. Dadurch können größere Kontaktflächen zur Kontaktierung des piezokeramischen Mehrschichtaktuators bereitgestellt werden. Vorzugsweise befinden sich zwei passive Bereiche in einer Richtung senkrecht zur Erstreckungsrichtung der Piezokeramikschichten an entgegen gesetzten Enden des Aktorkörpers.

Es kann von Vorteil sein, wenn die geometrischen Abmessungen der passiven Bereiche unterschiedlich sind. Diese Ausführung gestattet gewisse Freiräume bei der Gestaltung des Mehrschichtaktuators.

Erfindungsgemäß sind die Kontaktierungselektroden in Bereichen des Aktorkörpers angeordnet, die mit einer Grundmetallisierung versehen sind. Mehrere positive und mehrere negative Kontaktierungselektroden sind vorzugsweise jeweils in bestimmten zusammenhängenden Bereichen des Aktorkörpers angeordnet, die elektrisch voneinander isoliert sind. Dies sind vorzugsweise die passiven Bereiche des Aktorkörpers, in welchen kein (inverser) piezokeramischer Effekt hervorgerufen wird. Ein mit einer Grundmetallisierung versehener Bereich ist vorzugsweise ein Teilbereich eines passiven Bereichs des Aktorkörpers. Die mit einer Grundmetallisierung versehenen Bereiche mit unterschiedlicher elektrischer Polarität sind elektrisch voneinander isoliert. Bevorzugt sind in den mit einer Grundmetallisierung versehenen Bereichen die elektrodierten Oberflächen und/oder die Schmalseiten der passiven Schichten mit einer zusammenhängenden Grundmetallisierung versehen, so dass die elektrische Leitfähigkeit dort erheblich verbessert ist. Vereinfacht wird von Bereichen des Aktorkörpers mit einer Grundmetallisierung gesprochen. Durch Kontaktierungssammelelektroden kann eine Kontaktfläche noch weiter vergrößert werden.

Es kann praktisch sein, wenn die Grundmetallisierung durch Sputtern, Bedampfen, Dickschichttechnik, Leitklebstoffe aufgebracht ist. Derartige Metallisierungsverfahren können mit verhältnismäßig geringem Kostenaufwand bewerkstelligt werden.

Erfindungsgemäß sind die mit einer Grundmetallisierung versehenen Bereiche des Aktorkörpers durch Abstände voneinander getrennt, die nicht kleiner als die Dicke der Piezokeramikschichten im aktiven Bereich des Mehrschichtaktuators sind. Dadurch kann im gesamten Mehrschichtaktuator eine gleichmäßige Spannungsfestigkeit gewährleistet werden.

Zur Vermeidung von hohen inneren mechanischen Spannungen sind die Abstände der mit einer Grundmetallisierung versehenen Bereiche des Aktorkörpers vorzugsweise so gewählt, dass die elektrischen Feldstärken zwischen einer positiven und einer negativen Kontaktierungselektrode das 0,5 Fache der Koerzitivfeldstärke des verwendeten piezokeramischen Werkstoffes nicht übersteigen.

Es kann von Vorteil sein, wenn der Mehrschichtaktuator als Flächenaktuator ausgebildet und in Kunststoff eingebettet ist. Ein derartiges Piezokomposit ist robust und einfach zu handhaben und kann in verschiedensten Anwendungen zum Einsatz kommen.

Bevorzugte Weiterbildungen ergeben sich aus den Unteransprüchen.

### Kurze Beschreibung der Figuren

- Figur 1: zeigt eine perspektivische Darstellung eines herkömmlichen Aktuators nach dem Stand der Technik.
- Figur 2: zeigt den Aktuator gemäß Figur 1 im Querschnitt.
- Figur 3: zeigt einen Querschnitt eines weiteren Aktuators nach dem Stand der Technik.
- Figur 4: zeigt in perspektivischer Darstellung einen der Erläuterung dienenden Aktuator nach dem Stand der Technik.
- Figur 5: zeigt einen Querschnitt eines Aktuators gemäß Figur 4.
- Figur 6: zeigt einen Querschnitt eines erfindungsgemäßen Aktuators nach dem ersten Ausführungsbeispiel, wobei die Kontaktierungselektroden in einer passiven Endschicht des Aktorkörpers in mit Grundmetallisierungen versehenen Bereichen angeordnet sind.
- Figur 7: zeigt einen Querschnitt eines erfindungsgemäßen Aktuators nach dem zweiten Ausführungsbeispiel, wobei die Kontaktierungselektroden in verschiedenen passiven Endschichten des Aktorkörpers in mit Grundmetallisierungen versehenen Bereichen angeordnet sind.

### Detaillierte Beschreibung der bevorzugten Ausführungsbeispiele

Der erfindungsgemäße piezokeramische Mehrschichtaktuator 1 umfasst einen Aktorkörper mit einer Vielzahl von Piezokeramikschichten 4, die alternierend durch jeweils eine positive oder negative Innenelektrode 2, 3 voneinander getrennt sind, sowie positive und negative Sammelelektroden 9, 10, die auf zwei Außenseiten des Aktorkörpers angeordnet und mit den zugeordneten positiven oder negativen Innenelektroden 2, 3 leitend verbunden sind. Der Aktorkörper des Mehrschichtaktuators 1 weist zumindest je eine positive und eine negative Kontaktierungselektrode 7, 8 auf, über welche der Mehrschichtaktuator 1 elektrisch kontaktiert wird und welche mit der zugeordneten positiven oder negativen Sammelelektrode 9, 10 leitend verbunden ist.

Vorzugsweise wird der Aktorkörper bereits im grünen Zustand mit passiven Endschichten versehen und in diese passiven Bereiche 5, 6 werden Kontaktierungselektroden 7, 8 eingebracht, die an den eigentlichen Kontaktflächen des Aktuators 1 bis an die Oberfläche reichen und die in der Mitte des Aktuators 1 elektrisch gegeneinander isoliert sind. Nach dem Sägeprozess sind die so eingebrachten Kontaktierungselektroden 7, 8 von den Hauptflächen der Aktuatorplatte für eine elektrische Kontaktierung zugänglich, wobei dies über zusätzlich aufgebrachte strukturierte Sammelelektroden erfolgen kann.

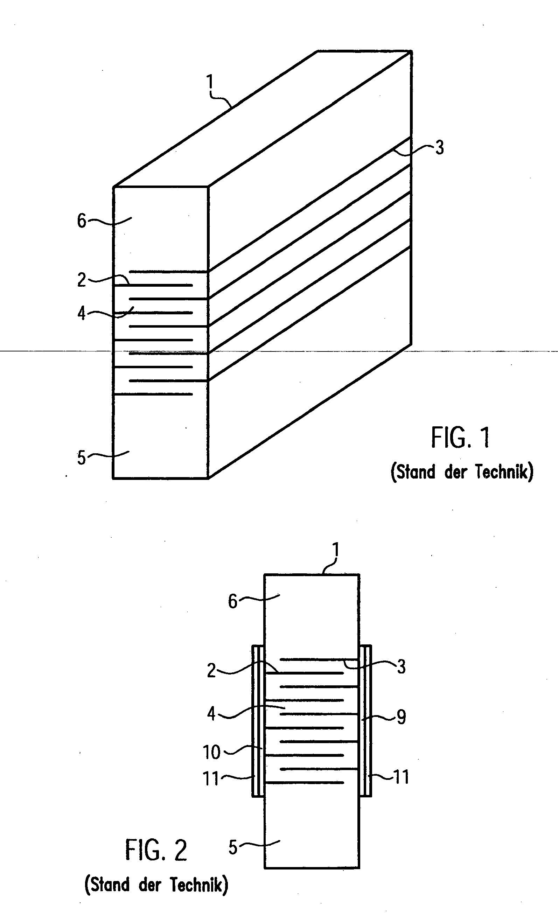

Figur 1 zeigt eine perspektivische Darstellung eines herkömmlichen Aktuators 1 mit Innenelektroden 2 und 3, den zwischen den Innenelektroden 2 und 3 liegenden aktiven Piezokeramikschichten 4 und den passiven Bereichen 5 und 6 mit passiven Keramikschichten.

Figur 2 zeigt einen Aktuator 1 gemäß Figur 1 im Querschnitt. Zusätzlich dargestellt sind hier die auf den Kontaktflächen des Aktuators 1 aufgebrachten Sammelelektroden 9 und 10 und den darauf applizierten Kontaktflächen 11, die sich auch über die gesamte Länge des Aktuators 1 erstrecken können.

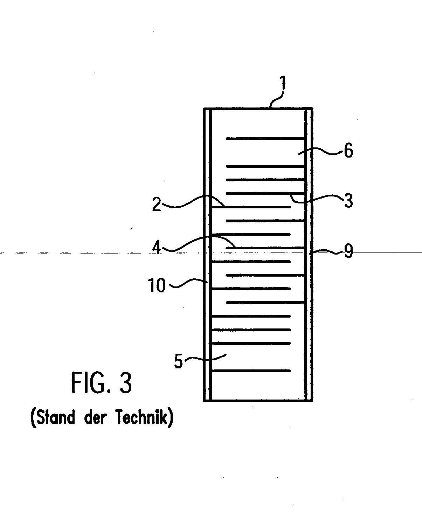

Figur 3 zeigt einen Querschnitt eines Aktuators 1 gemäß den Lehren der Druckschrift DE 11 2005 001 022 T5.

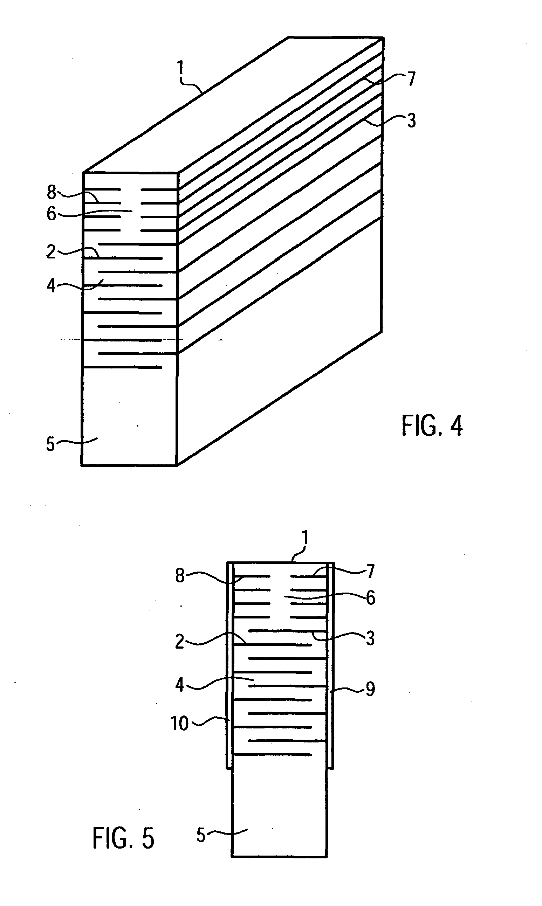

Figur 4 zeigt in perspektivischer Darstellung zur Erläuterung einen Aktuator 1 ähnlich der Lehre der JP2003-243740A (kein Ausführungsbeispiel der Erfindung) mit Innenelektroden 2 und 3, den aktiven Piezokeramikschichten 4 im aktiven Bereich des Aktuators 1 und den passiven Piezokeramikschichten in den passiven Bereichen 5 und 6 mit den erfindungsgemäß eingebrachten Kontaktierungselektroden 7 und 8. Die Kontaktierungselektroden 7 und 8 können sowohl in einer als auch in beiden passiven Bereichen 5 und 6 eingebracht werden. Es ist auch möglich, dass die geometrischen Abmessungen der passiven Keramikschichten in den passiven Bereichen 5 und 6 deutlich unterschiedlich ausgebildet sind. Vorzugsweise umfasst jeder der passiven Bereiche 5 und 6 Piezokeramikschichten, wie sie auch im aktiven Bereich des Aktorkörpers eingesetzt werden. Im Unterschied zum aktiven Bereich werden die Keramikschichten der passiven Bereiche 5 und 6 nicht alternierend von einer positiven oder negativen Innenelektrode 2 und 3 getrennt, sondern von sowohl einer positiven als auch einer negativen Kontaktierungselektrode 7 und 8, die von den mit Sammelelektroden 9 und 10 versehenen Außenseiten jeweils über ca. 20 bis 40 %, vorzugsweise 25 bis 35%, bevorzugt 30% des Abstands der Sammelelektroden 9 und 10 in den Aktorkörper hineinragen und in der Mitte elektrisch voneinander isoliert sind.

Figur 5 zeigt einen Querschnitt eines Aktuators 1 gemäß Figur 4 mit eingebrachten Kontaktierungselektroden 7, 8 in den passiven Bereichen 5, 6. Dabei werden die Kontaktierungselektroden 7 im passiven Bereich 5 über die Sammelelektrode 9 mit den Innenelektroden 3 des aktiven Bereichs leitend verbunden und die Kontaktierungselektroden 8 des passiven Bereichs 5 über die Sammelelektrode 10 mit den Innenelektroden 2 des aktiven Bereichs leitend verbunden.

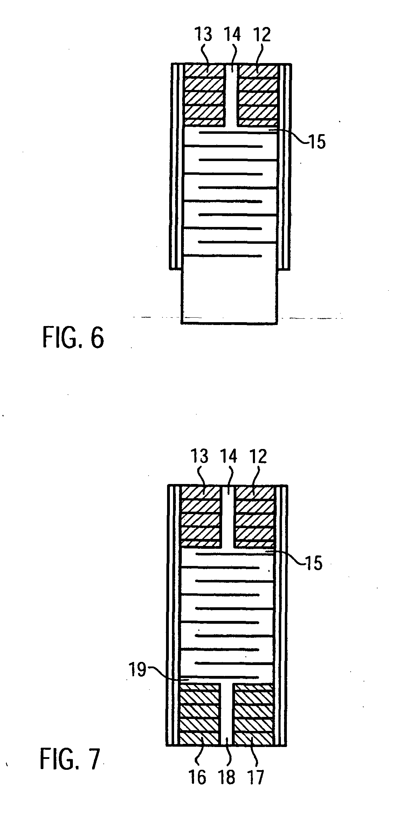

Figur 6 und Figur 7 zeigen Querschnitte der Aktuatoren nach dem ersten bzw. zweiten Ausführungsbeispiel der Erfindung mit Kontaktierungselektroden in den passiven Bereichen wie in Fig. 4 und 5. Zur besseren äußeren Kontaktierung des Aktuators sind die Bereiche der Kontaktierungselektroden mit weiteren Grundmetallisierungen 12, 13, 16, 17 versehen, die untereinander durch die Abstände 14 und 18 und zu den Innenelektroden durch die Abstände 15 und 19 beabstandet sind. Die Grundmetallisierungen können unter Berücksichtung weiterer Aufbaukriterien durch alle bekannten Metallisierungsverfahren wie bspw. Sputtern, Bedampfen, Dickschichttechnik, Leitklebstoffe usw. aufgebracht werden. Um eine gleichmäßige Spannungsfestigkeit im gesamten Aktuator zu gewährleisten, sollten die Abstände 14, 15, 18 und 19 nicht kleiner als die Dicke der aktiven keramischen Schichten gewählt werden. In vorteilhafter Weise werden sie zur Vermeidung von hohen inneren mechanischen Spannungen so gewählt, dass die elektrischen Feldstärken zwischen Elektroden mit unterschiedlichem elektrischen Potenzial das 0,5 Fache der Koerzitivfeldstärke des verwendeten piezokeramischen Werkstoffes nicht übersteigt.

Bei den erfindungsgemäßen Aktuatoren kann es sich als günstig erweisen, die Bereiche mit den Kontaktaktierungselektroden in der Mitte anstatt an den Enden des Aktuators anzuordnen. Auch ist der Lösungsansatz nicht auf quaderförmige Mehrschichtaktuatoren beschränk, vielmehr kann er in allen gebräuchlichen Bauformen realisiert werden. Grundsätzlich ist es auch möglich, die aktiven Bereiche mit den Innenelektroden und die passiven Bereiche mit den Kontaktierungselektroden getrennt herzustellen und im gesinterten Zustand durch übliche Aufbau- und Verbindungsverfahren wie zum Beispiel Kleben miteinander zu verbinden.

Mit der vorliegenden Erfindung ist eine sichere Kontaktierung von piezokeramischen Mehrschichtaktuatoren, insbesondere von dünnen Multilayerplatten in Flächenaktuatoren, gegeben. Neben der Kontaktierung von Multilayeraktoren für Flächenwandler kann diese Art der Kontaktierung für alle herkömmlichen Multilayeraktoren eingesetzt werden. Insbesondere der Einbau von Aktuatoren in komplexe mechanische Systeme kann dadurch erleichtert werden, da die äußere Kontaktierung der Aktuatoren auf einer Außenfläche erfolgen kann.

## Patentansprüche

1. Piezokeramischer Mehrschichtaktuator (1), umfassend: Einen Aktorkörper mit einer Vielzahl von Piezokeramikschichten (4), die alternierend durch jeweils eine positive oder negative Innenelektrode (2,3) voneinander getrennt sind, positive und negative Sammelelektroden (9,10), die auf zwei Aussenseiten des Aktorkörpers angeordnet und mit den zugeordneten positiven oder negativen Innenelektroden (2,3) leitend verbunden sind, wobei der Aktorkörper des Mehrschichtaktuators (1) Keramikschichten aufweist, die durch zumindest je eine positive und eine negative Kontaktierungselektrode (7,8) getrennt sind, über welche der Mehrschichtaktuator (1) elektrisch kontaktiert wird und welche mit der zugeordneten positiven oder negativen Sammelelektrode (9,10) leitend verbunden ist, und die Kontaktierungselektroden (7,8) in Bereichen (12,13,16,17) des Aktorkörpers angeordnet sind, die mit einer Grundmetallisierung versehen sind, **dadurch gekennzeichnet dass** die mit einer Grundmetallisierung versehenen Bereiche (12,13,16,17) des Aktorkörpers durch Abstände (14,18) voneinander und Abstände (15,19) zu den Innenelektroden getrennt sind, wobei die Abstände (14,15,18,19) nicht kleiner als die Dicke der Piezokeramikschichten (4) im aktiven Bereich des Mehrschichtaktuators (1) sind.

2. Piezokeramischer Mehrschichtaktuator (1) nach Anspruch 1, **dadurch gekennzeichnet, dass** die positive und/oder die negative Kontaktierungselektrode (7,8) an zumindest eine Aussenseite, vorzugsweise zwei Aussenseiten, des Aktorkörpers reicht, bevorzugt bündig mit der oder den Aussenseiten des Aktorkörpers abschliesst.

3. Piezokeramischer Mehrschichtaktuator (1) nach einem der vorangegangenen Ansprüche, **dadurch gekennzeichnet, dass** die positive und/oder die negative Kontaktierungselektrode (7,8) eine Innenseite der zugeordneten positiven oder negativen Sammelelektrode (9,10) unmittelbar kontaktiert.

4. Piezokeramischer Mehrschichtaktuator (1) nach einem der vorangegangenen Ansprüche, **dadurch gekennzeichnet, dass** die Sammelelektroden (9,10) auf zwei sich gegenüberliegenden Aussenseiten des Aktorkörpers angeordnet sind.

5. Piezokeramischer Mehrschichtaktuator (1) nach einem der vorangegangenen Ansprüche, **dadurch gekennzeichnet, dass** der Aktorkörper des piezokeramischen Mehrschichtaktuators (1) quaderförmig oder plattenfömig ausgebildet ist.

6. Piezokeramischer Mehrschichtaktuator (1) nach einem der vorangegangenen Ansprüche, **dadurch gekennzeichnet, dass** der Aktorkörper zumindest einen passiven Bereich (5,6) aufweist, der ausserhalb der äussersten beiden Innenelektroden (2,3) liegt, wobei die positive und/oder die negative Kontaktierungselektrode (7,8) innerhalb des passiven Bereichs (5,6) angeordnet ist.

7. Piezokeramischer Mehrschichtaktuator (1) nach einem der vorangegangenen Ansprüche, **dadurch gekennzeichnet, dass** der passive Bereich (5,6) zumindest eine Piezokeramikschicht (4) aufweist.

8. Piezokeramischer Mehrschichtaktuator (1) nach einem der vorangegangenen Ansprüche, **dadurch gekennzeichnet, dass** der Aktorkörper mehrere passive Bereiche (5,6) aufweist, in welchen mindestens eine positive und/oder mindestens eine negative Kontaktierungselektrode (7,8) angeordnet ist.

9. Piezokeramischer Mehrschichtaktuator (1) nach Anspruch 8, **dadurch gekennzeichnet, dass** die geometrischen Abmessungen der passiven Bereiche (5,6) unterschiedlich sind.

10. Piezokeramischer Mehrschichtaktuator (1) nach einem der vorangegangenen Ansprüche, **dadurch gekennzeichnet, dass** die Abstände (14,15,18,19) so gewählt sind, dass die elektrischen Feldstärken zwischen einer positiven und einer negativen Kontaktierungselektrode (7,8) das 0,5 Fache der Koerzitivfeldstärke des verwendeten piezokeramischen Werkstoffes nicht übersteigt.

11. Piezokeramischer Mehrschichtaktuator (1) nach einem der vorangegangenen Ansprüche, **dadurch gekennzeichnet, dass** der Mehrschichtaktuator (1) als Flächenaktuator ausgebildet und in Kunststoff eingebettet ist.

## Claims

1. Multilayer piezoceramic actuator (1) comprising: an actuator body with a plurality of piezoceramic layers (4) which are separated from each other by means of a positive or negative internal electrode (2, 3) in alternation, positive and negative collecting electrodes (9, 10) which are arranged on two outer faces of the actuator body and are conductively connected to the associated positive or negative internal electrodes (2, 3), wherein the actuator body of the multilayer actuator (1) has ceramic layers that are separated by at least one positive and one negative contacting electrode (7, 8), by means of each of which the multilayer actuator (1) is electrically contacted and each of which is conductively connected to the associated positive or negative collecting electrode (9, 10), and the contacting electrodes (7, 8) are arranged in areas (12, 13, 16, 17) of the actuator body that are provided with a base metallization, **characterized in that** the areas (12, 13, 16, 17) of the actuator body that are provided with a base metallization are spaced apart from each other by distances (14, 18) and from the internal electrodes by distances (15, 19), wherein the distances (14, 15, 18, 19) are not less than the thickness of the piezoceramic layers (4) in the active area of the multilayer actuator (1).

2. Multilayer piezoceramic actuator (1) according to claim 1, **characterized in that** the positive and/or the negative contacting electrode (7, 8) reaches to at least one outer face, preferably two outer faces, of the actuator body, and preferably ends flush with the outer face or outer faces of the actuator body.

3. Multilayer piezoceramic actuator (1) according to one of the preceding claims, **characterised in that** the positive and / or the negative contacting electrode (7, 8) directly contacts an inner face of the associated positive or negative collecting electrode (9, 10).

4. Multilayer piezoceramic actuator (1) according to one of the preceding claims, **characterized in that** the collecting electrodes (9, 10) are arranged on two opposite outer faces of the actuator body.

5. Multilayer piezoceramic actuator (1) according to one of the preceding claims, **characterised in that** the actuator body of the multilayer piezoceramic actuator (1) is formed with a cuboid or plate-like shape.

6. Multilayer piezoceramic actuator (1) according to one of the preceding claims, **characterised in that** the actuator body has at least one passive area (5, 6) that lies outside the two outermost internal electrodes (2, 3), wherein the positive and / or the negative contacting electrode (7, 8) is arranged within the passive area (5, 6).

7. Multilayer piezoceramic actuator (1) according to one of the preceding claims, **characterised in that** the passive area (5, 6) has at least one piezoceramic layer (4).

8. Multilayer piezoceramic actuator (1) according to one of the preceding claims, **characterised in that** the actuator body has a plurality of passive areas (5, 6) in which at least one positive and / or at least one negative contacting electrode (7, 8) is arranged.

9. Multilayer piezoceramic actuator (1) according to claim 8, **characterised in that** the geometric dimensions of the passive areas (5, 6) differ.

10. Multilayer piezoceramic actuator (1) according to one of the preceding claims, **characterised in that** the distances (14, 15, 18, 19) are selected in such a way that the electric field strengths between a positive and a negative contacting electrode (7, 8) do not exceed 0.5 times the coercive field strength of the piezoceramic material that is used.

11. Multilayer piezoceramic actuator (1) according to one of the preceding claims, **characterised in that** the multilayer actuator (1) is formed as a surface actuator and is embedded in plastic.

## Revendications

1. Actionneur piézocéramique multicouche (1) comprenant :
un corps d'actionneur avec un grand nombre de couches piézocéramiques (4), qui sont mutuellement séparées de manière alternée respectivement par une électrode intérieure positive ou négative (2, 3),
des électrodes collectrices (9, 10) positives et
négatives, qui sont agencées sur deux côtés extérieurs du corps d'actionneur, et sont reliées par une connexion conductrice avec les électrodes intérieures (2, 3) positives ou négatives associées,
actionneur dans lequel le corps d'actionneur de l'actionneur multicouche (1) présente des couches de céramique, qui sont séparées respectivement par au moins une électrode de contact (7, 8) positive et négative,
par l'intermédiaire de laquelle l'actionneur multicouche (1) est contacté électriquement, et qui est reliée par une connexion conductrice avec l'électrode collectrice positive ou négative (9, 10) associée, et les électrodes de contact (7, 8) sont agencées dans des zones (12, 13, 16, 17) du corps d'actionneur, qui sont munies d'une métallisation de base,
**caractérisé en ce que** les zones (12, 13, 16, 17) du corps d'actionneur munies d'une métallisation de base,
sont séparées par des distances d'espacement (14, 18) les unes des autres et par des distances d'espacement (15, 19) par rapport aux électrodes intérieures, les distances d'espacement (14, 15, 18, 19) n'étant pas inférieures à l'épaisseur des couches piézocéramiques (4) dans la zone active de l'actionneur multicouche (1).

2. Actionneur piézocéramique multicouche (1) selon la revendication 1, **caractérisé en ce que** l'électrode de contact (7, 8) positive et/ou négative s'étend jusqu'à au moins un côté extérieur, de préférence deux côtés extérieurs du corps d'actionneur, et arrive de préférence au ras du ou des côtés extérieurs.

3. Actionneur piézocéramique multicouche (1) selon l'une des revendications précédentes, **caractérisé en ce que** l'électrode de contact (7, 8) positive et/ou négative contacte directement un côté intérieur de l'électrode collectrice (9, 10) positive ou négative associée.

4. Actionneur piézocéramique multicouche (1) selon l'une des revendications précédentes, **caractérisé en ce que** les électrodes collectrices (9, 10) sont agencées sur deux côtés extérieurs mutuellement opposés du corps d'actionneur.

5. Actionneur piézocéramique multicouche (1) selon l'une des revendications précédentes, **caractérisé en ce que** le corps d'actionneur de l'actionneur piézocéramique multicouche (1) est d'une configuration parallélépipédique ou en forme de plaque.

6. Actionneur piézocéramique multicouche (1) selon l'une des revendications précédentes, **caractérisé en ce que** le corps d'actionneur présente au moins une zone passive (5, 6), qui est située à l'extérieur des deux électrodes intérieures (2, 3) les plus à l'extérieur, l'électrode de contact (7, 8) positive et/ou négative étant agencée à l'intérieur de la zone passive (5, 6).

7. Actionneur piézocéramique multicouche (1) selon l'une des revendications précédentes, **caractérisé en ce que** la zone passive (5, 6) présente au moins une couche piézocéramique (4).

8. Actionneur piézocéramique multicouche (1) selon l'une des revendications précédentes, **caractérisé en ce que** le corps d'actionneur présente plusieurs zones passives (5, 6), dans lesquelles est agencée au moins une électrode de contact (7, 8) positive et/ou au moins une électrode de contact négative.

9. Actionneur piézocéramique multicouche (1) selon la revendication 8, **caractérisé en ce que** les dimensions géométriques des zones passives (5, 6) sont différentes.

10. Actionneur piézocéramique multicouche (1) selon l'une des revendications précédentes, **caractérisé en ce que** les distances d'espacement (14, 15, 18, 19) sont choisies de manière telle, que les intensités de champs électriques entre une électrode de contact (7, 8) positive et une électrode de contact négative, ne dépassent pas 0,5 fois l'intensité de champ coercitif du matériau piézocéramique utilisé.

11. Actionneur piézocéramique multicouche (1) selon l'une des revendications précédentes, **caractérisé en ce que** l'actionneur multicouche (1) est réalisé en tant qu'actionneur de surface et est noyé dans une matière plastique.
